# EUROPEAN PATENT SPECIFICATION

(11) **EP 2 625 533 B1**
(45) Date of publication and mention of the grant of the patent: **29.09.2021**
(21) Application number: 10858059.8
(22) Date of filing: 04.10.2010
(51) Int. Cl.: G01R 19/165

(54) **LOW-VOLTAGE EXIT DETECTOR, ERROR DETECTOR, LOW-VOLTAGE SAFE CONTROLLER, BROWN-OUT DETECTION METHOD, AND BROWN-OUT SELF-HEALING METHOD**
NIEDERSPANNUNGSAUSGANGSDETEKTOR, FEHLERDETEKTOR, SICHERE NIEDERSPANNUNGSSTEUERUNG, VERFAHREN ZUR ERKENNUNG VON BÜSCHELENTLADUNG UND SELBSTWIEDERHERSTELLUNGSVERFAHREN FÜR BÜSCHELENTLADUNG
DÉTECTEUR DE SORTIE BASSE TENSION, DÉTECTEUR D'ERREUR, UNITÉ DE COMMANDE SÛRE BASSE TENSION, PROCÉDÉ DE DÉTECTION D'ÉCLAIRAGE RÉDUIT ET PROCÉDÉ D'AUTO-RÉTABLISSEMENT D'ÉCLAIRAGE RÉDUIT

(43) Date of publication of application: 14.08.2013
(73) Proprietor: NXP USA, Inc., Austin TX 78735 (US)
(72) Inventor: ROHLEDER, Michael, 85716 Unterschleissheim (DE); DOLL, Stefan, 80335 München (DE); LUEDEKE, Thomas, 84564 Oberbergkirchen (DE)
(74) Representative: Hardingham, Christopher Mark
(86) International application number: PCT/IB2010/054467
(87) International publication number: WO 2012/046097

(56) References cited:
- US-A- 5 894 423
- US-A- 5 943 635
- US-A1- 2003 227 306
- US-A1- 2006 066 258
- US-B1- 6 954 083

## Description

### Field of the invention

This invention relates to a low-voltage exit detector, an error detector, a low-voltage safe controller, a brown-out detection method, and a brown-out self-healing method.

### Background of the invention

For defining a trigger point of a low-voltage detector, production tolerances, measurement tolerances, and aging effects have to be taken into account. Usually, a conservative approach is chosen, to assure that the low-voltage detector triggers a reset before any possibility of a brown-out effect can be expected.

US 6,954,083 B1 for instance describes a fault detector circuit for detection of faults on an integrated circuit due to supply voltage fluctuations of short duration. The fault detector circuit comprises a VBO/POR circuit, which monitors the supply voltage, detects a drop of the supply voltage below a predetermined voltage and outputs a "voltage brownout" VBO, which initializes a microcontroller to a known starting value. The fault detector circuit further comprises a plurality of fault detectors and a logical tree, which issues an (active high) fault signal FAULT in response to an (active low) signal received from any one of the fault detectors indicative of a state error of a flip-flop thereof. The fault signal FAULT generated by the logical tree is supplied to the VBO/POR circuit, which in turn resets the program counter of the processor and resets the fault detectors.

### Summary of the invention

The present invention provides a low-voltage exit detector, an error detector, a low-voltage safe controller, a brown-out detection method, and a brown-out self-healing method, as described in the accompanying independent claims.

Specific embodiments of the invention are set forth in the dependent claims.

These and other aspects of the invention will be apparent from and elucidated with reference to the embodiments described hereinafter. Wherever the term "embodiment" refers to the invention, it is understood that the term "embodiment" refers exclusively to the subject-matter which is defined in the claims and limited thereby.

### Brief description of the drawings

Further details, aspects and embodiments of the invention will be described, by way of example only, with reference to the drawings. In the drawings, like reference numbers are used to identify like or functionally similar elements. Elements in the figures are illustrated for simplicity and clarity and have not necessarily been drawn to scale.
Fig. 1 schematically shows in its upper part an example of a curve of an absolute value of a supply voltage of an energy supply for an electronic control. The lower part of the figure shows an example embodiment of a curve of a warning signal and two example embodiments of curves of trigger signals.
Fig. 2 schematically shows an example embodiment of a low-voltage safe controller comprising an example embodiment of an error detector. The error detector comprises an example embodiment of a low-voltage exit detector.
Fig. 3 schematically shows an example embodiment of a low-voltage rise detector.
Fig. 4 schematically shows an example embodiment of a low-voltage safe controller comprising an example embodiment of an error detector. The error detector comprises an example embodiment of a low-voltage exit detector.
Fig. 5 shows an example embodiment of Verilog® (IEEE Standard 1364-2001) code compriing an example embodiment of a comparator for comparing a pattern comprising a first and second stored information to a set of predefined valid patterns.
Fig. 6 schematically shows another example embodiment of a comparator for comparing stored information.
Fig. 7 schematically shows an example embodiment of a coder for encoding a first retrieved information using a second coding scheme.
Fig. 8 schematically shows an example embodiment of a brown-out detection method and of a brown-out self-healing method.

### Detailed description of the preferred embodiments

Because the illustrated embodiments of the present invention may for the most part, be implemented using electronic components and circuits known to those skilled in the art, details will not be explained in any greater extent than that considered necessary as illustrated above, for the understanding and appreciation of the underlying concepts of the present invention and in order not to obfuscate or distract from the teachings of the present invention. In the context of the specification it may be assumed that any device capable of switching on and off a current may also be able to control a strength of the current switched. A current strength control and/or a switching may be performed based on a control current or control voltage, for example in the context of transistors. A control of the current may be performed continuously. Lines for transfer of information may comprise at least one of a wireline interface, a radio interface, or an optical interface.

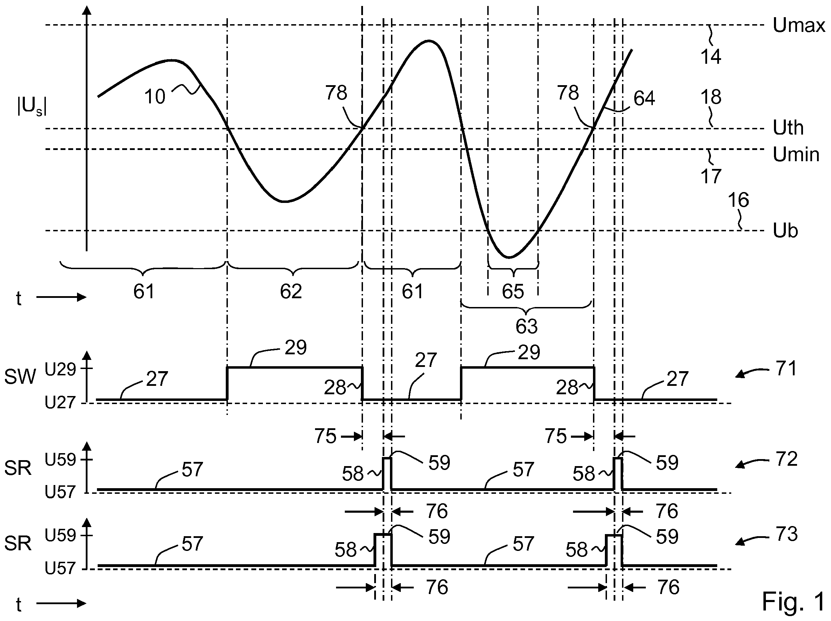

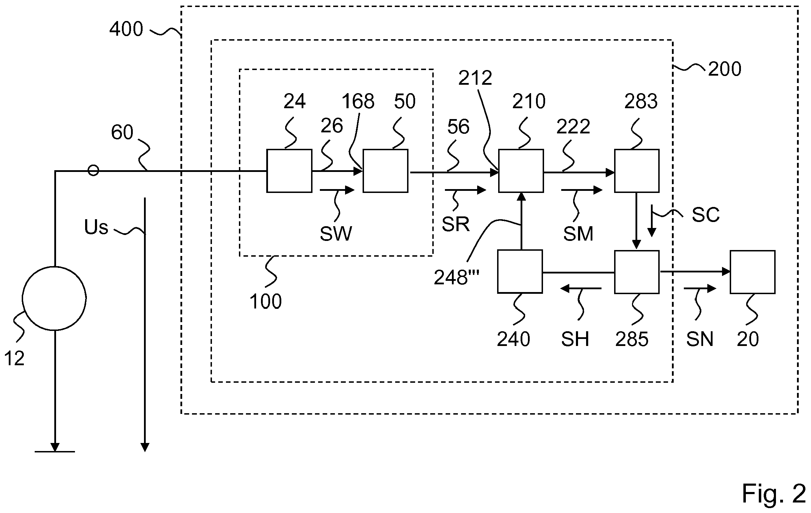

The upper part of Fig. 1 schematically shows an example curve 10 of an absolute value |Us| of a watched voltage Us over time. The watched voltage Us may be employed for supplying an application unit 20 or a low-voltage safe controller 400 comprising the application unit 20 with electrical energy from an energy supply 12 (see Fig. 2). Dashed drawing line 14 represents an upper limit Umax of the absolute value |Us| of the watched voltage Us. To guarantee safe operation of the application unit 20, the absolute value |Us| of the watched voltage Us shall not underrun Umin (dashed drawing line 17). To guarantee safe operation of the application unit 20, the absolute value |Us| of the watched voltage Us shall not exceed Umax (dashed drawing line 14).

Dashed drawing Line 16 represents a lower limit Ub of the absolute value |Us| of the watched voltage Us. When the absolute value |Us| of the watched voltage Us drops below Ub, there may be a risk that the application unit 20 may work incorrectly. Hence, Ub may be a minimum absolute value |Us| of the watched voltage Us required for safe operation of the application unit 20. This voltage level Ub may be called "brown-out voltage".

Dashed drawing line 18 represents a threshold voltage Uth of a low-voltage detector 24 as shown in Fig. 2. The value of Uth may be specified dependent on at least one of the value of the brown-out voltage Ub, on a tolerance of the low-voltage detector 24, on a tolerance of measurement tools for trimming the low-voltage detector 24, and on a margin to be added to account for aging effects of the semiconductors of the low-voltage detector 24.

Typical values are: +/- 5 % tolerance for the low-voltage detector 24, +/- 3 % tolerance for the measurement tools for trimming the low-voltage detector 24, and 2 to 5 % margin to be added to account for aging effects of the semiconductors of the low-voltage detector 24. For a 1.2V voltage rail, the minimal operating voltage Umin may be 1.08 V. The maximal operating voltage Umax may be 1.32 V. The brown-out voltage Ub may be 0.95 V.

For this example: Taking solely the detection tolerance into account, the low-voltage detector may be constructed to trigger latest at 1.05 V to guarantee a detection of a low voltage condition before reaching the brown-out voltage level Ub. Adding the measurement tolerances and the margin for aging effects may lift the threshold voltage Uth to about 1.10 V to assert for a whole life-time of the low-voltage detector 24 that the low-voltage detector 24 always triggers before the absolute value |Us| of the watched voltage Us drops below the Ub of 0.95 V.

The lower part of Fig. 1 schematically shows a curve 71 of a warning signal SW provided by the low-voltage detector 24 at a warning signal line 26 (see Fig. 2). The low-voltage detector 24 may provide a warning signal SW having inactive warning status 27, when an absolute value |Us| of the watched voltage Us is higher than the threshold voltage Uth. The low-voltage detector 24 may provide a warning signal SW having an active warning status 29, when an absolute value |Us| of the watched voltage Us is lower than the threshold voltage Uth, wherein the active warning status 29 is different from the inactive warning status 27. The warning signal line 26 of the low-voltage detector 24 may be connected to an input line 168 of the voltage rise detector 50. The warning signal SW to be transmitted via the warning signal line 26 may be formed using a voltage U27 for indicating the inactive warning status 27 and using a second voltage U29 for indicating the active warning status 29. Alternatively, or in addition, the warning signal SW may be formed using two different digital codes, wherein a first digital code indicates the inactive warning status 27 and wherein a second digital code indicates the active warning status 29.

Fig. 2 schematically shows an example embodiment of a low-voltage exit detector 100 which may comprise a low-voltage detector 24 and a voltage rise detector 50. The low-voltage exit detector 100 may be a part of an error detector 200. The error detector 200 may be a part of a low-voltage safe controller 400. The low-voltage safe controller 400 may comprise the application unit 20. Each of the devices 20, 24, 50, 100, 200, 400 may be made of at least one of discrete and integrated components. All, or a subset of these devices 20, 24, 50, 100, 200, 400 may be integrated on a common substrate or a common die. Low-voltage events 62, 63 may impair functions of at least one of the application unit 20, the low-voltage safe controller 400, or the error detector 200. The low-voltage detector 24 may be constructed such that low-voltage events 62, 63 cannot impair its function. The voltage rise detector 50 may be constructed such that low-voltage events 62, 63 cannot impair its function. The low-voltage exit detector 100 may be constructed such that low-voltage events 62, 63 cannot impair any of its functions.

The low-voltage detector 24 may comprise a voltage detection line 60 for observing the watched voltage Us. The low-voltage detector 24 may be constructed for detecting a non-low-voltage condition 61, in which an absolute value |Us| of the watched voltage Us is higher than the threshold voltage Uth, and for detecting a low-voltage condition 62, 63, in which the absolute value |Us| is lower than the threshold voltage Uth.

Any absolute value |Us| below the threshold voltage Uth forms a potential low-voltage condition 62, 63. The low-voltage detector 24 may be constructed to generate and provide a warning signal SW indicating whether the watched voltage Us is in the non-low-voltage condition 61 or in the low-voltage condition 62, 63.

As the low-voltage detector 24 may have an overall tolerance, it may be impossible or cost-ineffective to provide a low-voltage detector 24, which can recognize the exact instant when the low-voltage condition 62, 63 is entered or left. When designing or setting the level of the threshold voltage Uth it may be necessary to take account for an overall tolerance of the low-voltage detector 24 for reliably changing the warning signal SW to the warning state 29, whenever a low-voltage condition 62, 63 occurs. In return, this may imply that the low-voltage detector 24 indicates the warning state 29 also at times or periods where the watched voltage Us is in fact not in a low-voltage condition 62, 63, but in a non-low-voltage condition 61. This interrelation should be kept in mind when regarding Fig. 1, which, for improving intelligibility, does not reflect tolerances.

The condition wherein the absolute value |Us| of the watched voltage Us is in fact lower than the threshold voltage Uth (i.e. when the watched voltage Us is in fact in a low-voltage condition 62, 63), may be called "possible brown-out condition". Occurrence of a possible brown-out condition may be a prerequisite for a possibility of an impact of a drop of the absolute value |Us| of the watched voltage Us to the correctness of the operation of any portion of the application unit 20.

The condition 65 wherein the absolute value |Us| of the watched voltage Us is in fact lower than the brown-out voltage Ub (i.e. when the watched voltage Us is in fact in a low-voltage condition 65), may be called "real brown-out condition". Occurrence of a real brown-out condition 65 may cause an impact to the correctness of the operation of any portion of the application unit 20.

The voltage rise detector 50 may be constructed to receive the warning signal SW from the low-voltage detector 24. The voltage rise detector 50 may be constructed to provide a trigger signal SR dependent on a curve 71 of the warning signal SW. Here, the warning signal SW is designated as a 'warning signal', because this signal may have the purpose to cause the voltage rise detector 50 to enter a prestage for a subsequent generation of the trigger signal SR. Although entering the prestage may be not sufficient for generating the trigger signal SR, entering the prestage may be a necessary precondition for generating the trigger signal SR. The low-voltage exit detector 100 may comprise a voltage rise detector 50 for detecting a change 28 of the warning signal SW from the active warning status 29 to the inactive warning status 27. The voltage rise detector 50 may be constructed to provide a trigger signal SR indicating a trigger status 59 at a trigger signal line 56 upon a detection of said change 28 of the warning signal SW. The voltage rise detector 50 may be constructed or suitable to provide the trigger signal SR at a trigger signal line 56 of the voltage rise detector 50 upon a detection of a rise 64 of said absolute value |Us| of said watched voltage Us passing the threshold voltage Uth. Summarized, the voltage rise detector 50 may be constructed for providing a trigger signal SR upon detection of a change 78 from a low-voltage condition 62, 63 of the watched voltage Us to a non-low-voltage condition 61 of the watched voltage Us.

The trigger signal SR may have a trigger status 59 for indicating that the warning signal SW has just changed 28 from an active warning status 29 to an inactive warning status 27. Else the voltage rise detector 50 may provide the trigger signal SR having a regular operation status 57 for indicating that the warning signal SW has not just changed 28 to the inactive warning status 27, wherein the warning status 59 of the trigger signal SR is different from the regular operation status 57 of the trigger signal SR. The trigger line 56 of the voltage rise detector 50 may be connected to a trigger signal input line 212 of a storage checker 210.

For reasons explained above, it may be necessary to take an overall tolerance of the low-voltage detector 24 into account for reliably generating the trigger signal SR, whenever an exit from a low-voltage condition 62, 63 occurs. In return, this may imply that the low-voltage exit detector 100 indicates an exit from a low-voltage condition 62, 63 of the watched voltage Us also when the watched voltage Us in fact has not entered the low-voltage condition 62, 63 before, but remained in the non-low-voltage condition 61.

The lower part of Fig. 1 schematically shows an example curve 72 of the trigger signal SR. As long as the absolute value |Us| of the watched voltage Us stays either above or below the threshold voltage Uth, the trigger signal SR may remain in the regular operation status 57. This still applies when the absolute value |Us| of the watched voltage Us changes from a value above the threshold voltage Uth to a value below the threshold voltage Uth. Upon a change 78 of the absolute value |Us| of the watched voltage Us from a value below the threshold voltage Uth to a value above the threshold voltage Uth, the trigger signal SR may change 58 to the trigger status 59. The trigger signal SR to be transmitted via the trigger line 56 may be formed using a first voltage U57 for indicating the regular operation status 57 and a second voltage U59 for indicating the trigger status 59. Alternatively, or in addition, the trigger signal SR may be formed using two different digital codes, wherein the first digital code indicates the regular operation status 57 and wherein the second digital code indicates the status 59.

The change 58 of the status of the trigger signal SR may happen at an end of a predefined or settable delay 75 after the change 28. The change 28 may be considered as caused by a change 78 of the sign of a difference between the threshold voltage Uth and the absolute |Us| of the watched voltage Us. If the curve 10 of the absolute value |Us| of the watched voltage Us returned to a value below the threshold voltage Uth within the period of the delay 75, a duration assertion device 51 may suppress a change 58 to the trigger status 59 and remain in the regular operation status 57. The trigger signal SR may remain in the regular operation status 57 until the absolute value |Us| of the watched voltage Us returned to a value above the threshold voltage Uth for a duration which is at least as long as the delay 75. After a predefined period 76 or after a settable period 76 the trigger signal SR may automatically return from the trigger status 59 to the regular operation status 57.

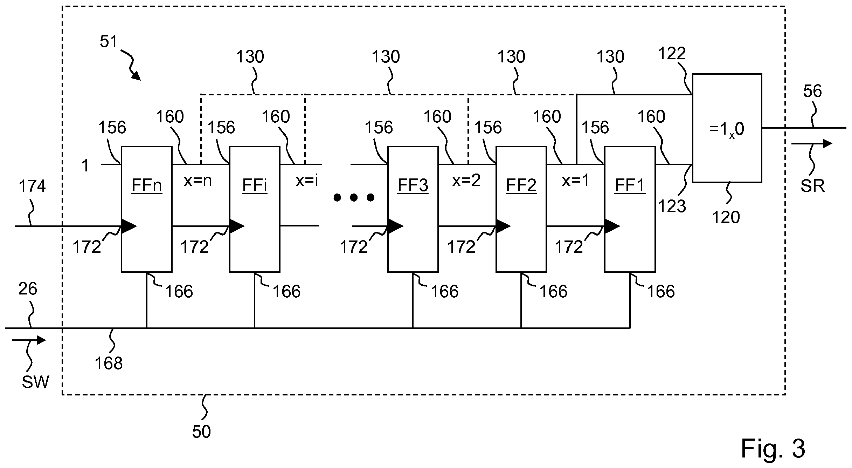

Fig. 3 schematically shows an example embodiment of a voltage rise detector 50. The voltage rise detector 50 may comprise a chain of flipflops FFn to FF1 having at least two flipflops FF1, FFn. The voltage rise detector 50 may comprise a first comparator 120. A first input terminal 123 of the first comparator 120 may be connected to an output line 160 of the last flipflop FF1 of the chain of flipflops. One or more further terminal(s) 122 of the comparator 120 may be connected via one or more line(s) 130 to one or more output line(s) 160 of one or more of the previous flipflops FFn to FF2 of the chain of flipflops. The first comparator 120 may provide a trigger signal SR at a trigger signal line 56. The trigger signal SR may have a value 'True', when a signal having the value 'True' is provided to all of the one or more terminal(s) 122 of the first comparator 120 and when simultaneously a signal having the value 'False' is provided to the first input terminal 123 of the first comparator 120. In all other cases the first comparator 120 may generate at its output line 56 for the trigger signal SR a 'False'.

The input terminal 156 of each subsequent flipflop FFi to FF1 may be connected to an output line 160 of the previous flipflop FFn to FF2, respectively. A reset terminal 166 of each of the flipflops FFn to FF1 may be connected to a common reset line 168 of the voltage rise detector 50. The common reset line 168 may be connected to the warning signal line 26 of the low-voltage detector 24 to receive the warning signal SW. A clock input terminal 172 of each flipflop FFn to FF1 of the voltage rise detector 50 may be connected to a common clock line 174 of the voltage rise detector 50. In other words, the flipflops FFn, .., FF1 of the at least one shift register FFn, .., FF1 may have preset terminals 166. The preset terminals 166 may be connected to the warning signal line 26. Each of the preset terminals may be either a reset terminal or a set terminal.

A reset of the flipflops may take place when a 'True' is provided to the common reset line 168. In a regular operation condition 61, the low-voltage detector 24 may provide a logical 'False' via the warning signal line 26 to the common reset line 168. Under this condition the flipflops FFn to FF1 will not be reset. With each clock the first flipflop FFn of the chain of flipflops FFn to FF1 may shift the 'True' (which may have a High Level) from an input terminal 156 of the first flipflop FFn to the input terminal 156 of the next flipflop FF2. In the chain of flipflops, with each clock, each subsequent flipflop may shift the 'True' from its input terminal 156 to the input terminal 156 of the next flipflop FF2. Thereby, the value at the input line 156 of first flipflop is shifted clock-by-clock in a direction towards the output line 160 of the last flipflop FF1. This continues until the value, originally received at the input line 156 of the first flipflop FFn either reached the output line 160 of the last flipflop FF1, or the common reset line 168 received via warning signal line 26 an indication of the active warning status 29. Hence, in a stationary status with regular operation all flipflops of the flipflop chain may provide a 'True' at their respective output 160. Note: 'Stationary' does not mean the same as 'static' and does not exclude clocking the voltage rise detector 50.

When entering the active warning status 29 from the inactive warning status 27, the common reset line 168 will reset all flipflops FFn to FF1 and modify their output line 160 to the value 'False'.

When changing 28 back from the active warning status 29 to the inactive warning status 27, the value at the input line 156 of first flipflop may start to be shifted clock-by-clock in a direction towards the output line 160 of the last flipflop FF1. At the end of this process a '1ₓ0' bit pattern may arrive at the input lines 122, 123 of the first comparator 120 and may cause a change 58 of the trigger signal SR from the regular operation status 57 to the trigger status 59. The duration of this process may be shortened by decreasing the number of shift stages for the one or more further input line(s) 122. The number of shift stages n - x (between the first flipflop FFn and the flipflop providing the output line 160 tapped by one or more of the line(s) 130) multiplied with the period of the clock (applied to the common clock line 174) may determine a length of the delay 75. As illustrated with curve 73, with the example embodiment of Fig. 3, the delay 76 may increase with decreasing delay 75, and vice versa. A shifting of the tap for line 130 may modify a number x of shift stages between the first 123 and further 122 input lines of the first comparator 120.

Summarized, the voltage rise detector 50 may comprise a set of flipflops FF1 to FFn. The voltage rise detector 50 may comprise at least a first flipflop FFn and a last flipflop FF1. Each of the first and the last flipflop FF1 or each of the flipflops of the set of flipflops FFn to FF1 may have a clock input terminal 172 and a reset input terminal 166. The reset input terminals 166 may be connected to a warning signal line 26 of the low-voltage detector 24. The warning signal line 26 of the low-voltage detector 24 for signaling the non-low-voltage condition 61 of the watched voltage Us and for signaling the low-voltage condition 62, 63 of the watched voltage Us may be connected to a common reset line 168 or to a common set line.

The voltage rise detector 50 as illustrated in Fig. 3 may comprise a duration assertion device 51 for asserting a duration of the period 75, in which the watched voltage Us has not changed from the non-low-voltage condition 61 to the low-voltage condition 62, 63 since a last change 78 from the low-voltage condition 62, 63 to the non-low-voltage condition 61. The voltage rise detector 50 may comprise at least one of an asynchronous and a synchronous shift register FFn to FF1 having at least two shift stages FFn, FF1. A warning signal line 26 of the low-voltage detector 24 may be connected to at least one of a common set line and a common reset line 168 of at least one of the voltage rise detector 50 and the shift register FFn to FF1.

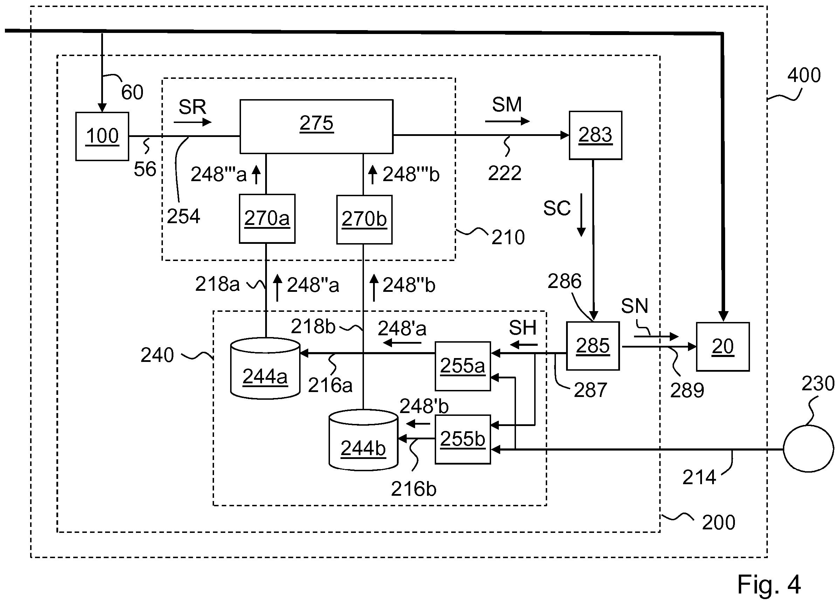

Fig. 4 schematically shows an example embodiment of an error detector 200 for detecting storage errors resulting from droppings 63 of an absolute value |Us| of the watched voltage Us. Here, the term 'storage error' designates an inadvertent change of a status of a storage element, wherein the status of the storage element 244a, 244b represents a stored information 248"a, 248"b stored in the storage element 244a, 244b. The error detector 200 may comprise at least one of a low-voltage exit detector 100, an input line 60 for voltage detection, a supervised information input line 214, a first 218a and a second 218b retrieval line, and a match-mismatch signal line 222. The supervised information input line 214 may be constructed for feeding the error detector 200 with supervised information 248. The supervised information 248 may be any data like source information, control information, program information, or configuration information. The error detector 200 may comprise a low-voltage exit detector 100, a storage checker 210, a first storage element 244a, a second storage element 244b, a first loader 255a, a second loader 255b, a synchronizer 283, and a correcting unit 285. Low-voltage events 62, 63 may impair functions of at least one of the storage elements 244a, 244b.

In other words, an error detector 200 for detecting storage errors may comprise at least one of following units: a low-voltage exit detector 100, a first loader 255a for loading 510a a first loading information 248'a into a first storage element 244a, wherein the first loading information 248'a is a supervised information 248 coded using a first coding scheme; a second loader 255b for loading 510b a second loading information 248'b into a second storage element 244b, wherein the second loading information 248'b is the supervised information 248 coded using a second coding scheme; a first retriever 270a for retrieving 540a a first stored information 248"a stored in the first storage element 244a; a second retriever 270b for retrieving 540b a second stored information 248"b stored in the second storage element 244b; and a second comparator 275 for comparing 550 a combination of a first retrieved information 248"'a retrieved using the first retriever 270a and a second retrieved information 248"'b retrieved using the second retriever 270b to each pattern of a set of valid patterns and for generating a match-mismatch signal SM indicating a result of this comparison 550.

The storage checker 210 may comprise a first retriever 270a, a second retriever 270b, and a second comparator 275. The storage checker 210 may comprise at least one of a trigger signal line 56 for receiving 520 a trigger signal SR, a first 218a and the second 218b retrieval line, and the match-mismatch signal line 222. The error detector 200 may comprise a first 244a and a second 244b storage element for storing the loading information 248'a, 248'b and keeping it as stored information 248"a, 248"b. The low-voltage exit detector 100 may be a low-voltage exit detector 100 as described before.

The first retriever 270a may be constructed to retrieve the first stored information 248"a from the first storage element 244a and to transfer the first retrieved information 248"'a to the second comparator 275. The first retriever 270a may comprise a first decoder for decoding the first stored information 248"a before transferring the first retrieved information 248"'a to the second comparator 275. When a first decoder is provided, a decoding algorithm of the first decoder may be complementary to an encoding algorithm of the first encoder.

The second retriever 270b may be constructed to retrieve second stored information 248"b from the second storage element 244b and to transfer the second retrieved information 248"'b to the second comparator 275. The second 270b retriever may comprise a second decoder for decoding the second stored information 248"b before transferring the second retrieved information 248"'b to the second comparator 275. When a first decoder is provided, a decoding algorithm of the second decoder may be complementary to an encoding algorithm of the second encoder.

A loading of the first loading information 248'a from a correcting unit 285 into the first storage element 244a may be performed via the first loading line 216a,. A loading of the second loading information 248'b from the correcting unit 285 into the second storage element 244b may be performed via the second loading line 216b.

If at least one or both of the first 244a and second 244b storage elements is external to the storage checker 210, the retrieving of the first stored information 248"a from the first 244a storage element to the storage checker 210 may be performed via the first retrieval line 218a. The retrieving of the second stored information 248"b from the second storage element 244b to the storage checker 210 may be performed via the second retrieval line 218b.

The storage checker 210 may comprise more than two retrievers 270a, 270b; with decoders for decoding the stored information 248"a, 248"b stored in the storage elements 244a, 244b or without decoders for using this stored information 248"a, 248"b directly. When existent the used encoder/decoder pairs 255a/270a, 255b/270b, etc. may comprise more than two pairs of encoding/decoding algorithms.

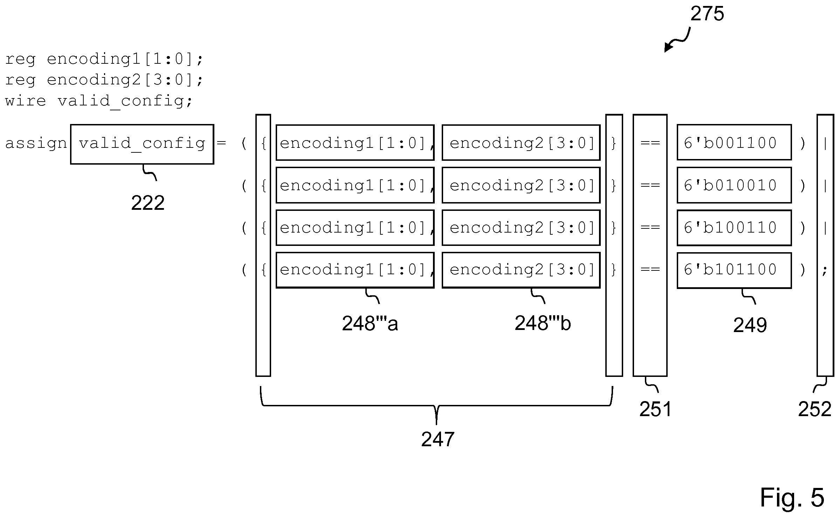

In an example embodiment, the second comparator 275 may be constructed to compare the combined output 248"'a of the first retriever 270a and output 248"'b of the second retriever 270b against a set of valid combinations for this data (as shown in Figure 5). The second comparator 275 may provide a match-mismatch signal SM indicating a match at the match-mismatch signal line 222 if the combined outputs 248'''a, 248"'b of both retrievers 270a, 270b match one of the valid combinations. The second comparator 275 may provide a match-mismatch signal SM indicating a mismatch at the match-mismatch signal line 222 if the outputs 248"'a, 248"'b of both retrievers 270a, 270b do not match any of the valid combinations.

In a further embodiment, the second comparator 275 may be constructed to compare an encoded and/or decoded output 248"'a of the first retriever 270a to an encoded and/or decoded output 248"'b of the second retriever 270b. In this case of embodiment, the second comparator 275 may provide a match-mismatch signal SM indicating a match at the match-mismatch signal line 222 if the outputs 248"'a, 248"'b of both retrievers 270a, 270b match. The second comparator 275 may provide a match-mismatch signal SM indicating a mismatch at the match-mismatch signal line 222 if the outputs 248'''a, 248"'b of both retrievers 270a, 270b do not match.

Fig. 5 shows an example embodiment of a comparator 275 for comparing 550 a pattern comprising first 248'''a and second 248"'b retrieved information to a set of valid patterns; encoded in the Verilog® RTL language (RTL = Register Transfer Level) as specified in IEEE Standard 1364-2001, ISBN 0-7381-2826-0. The signal encoding1 [1:0] (248'''a) specifies the output of two registers representing the storage element 244a, while the signal encoding2 [3:0] (248"'b) specifies the output of four registers representing the storage element 244b. Both signals are concatenated 247 and compared 251 with a set of valid encodings 249; for illustration purposes a different set of valid patterns has been chosen than for other examples. In this example we have again four possible sets of valid encodings that are OR"d together 252 and thus form the new signal valid_config forming the match-mismatch signal SM on the match-mismatch signal line 222; the following table shows the valid encodings. For all or any subset of the first stored codings 248"a there may more than one valid second stored coding 248"b assigned to the first stored coding 248"a (see valid patterns 3 and 4 of the example). For all or any subset of the second stored codings 248"b there may be more than one valid first stored coding 248"a assigned to the second stored coding 248"b (see valid patterns 1 and 4 of the example).

| | First stored coding (encoding1[1:0]) | Second stored coding (encoding2[3:0]) | SM (valid_ config) |
|---|---|---|---|
| Ref.No | 248"a | 248"b | SM |
| Valid pattern 1 | 00 | 1100 | Valid |
| Valid pattern 2 | 01 | 0010 | Valid |
| Valid pattern 3 | 10 | 0110 | Valid |
| Valid pattern 4 | 10 | 1100 | Valid |
| Any other pattern set | ... | | Invalid |

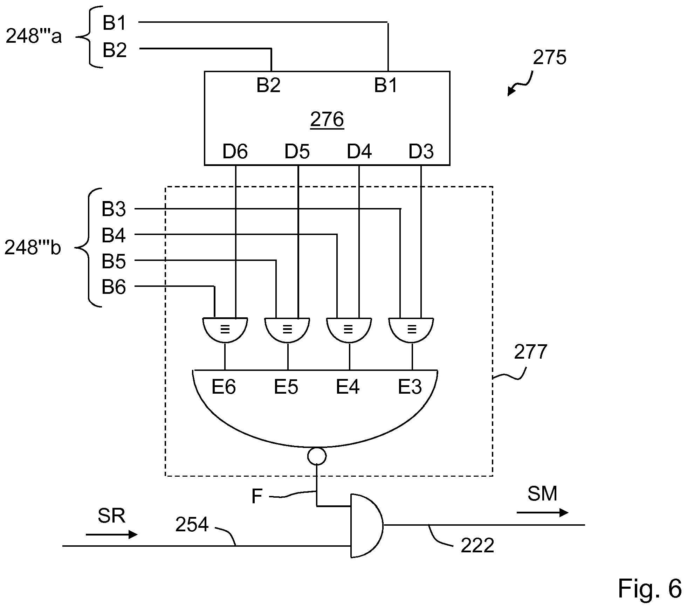

Fig. 6 schematically shows an example embodiment of a comparator 275 for indirectly comparing 550 a pattern comprising first 248"'a and second 248"'b retrieved information to a set of valid patterns. For the indirect comparison 550 of both patterns, the comparator 275 may comprise a coder 276 for encoding a first retrieved information 248"'a using the second coding scheme. The coder 276 may translate an input pattern having input bits B1, B2 to an output pattern having bits D3 to D6. The number of input bits B1, B2 may be equal to the number of bits of the first retrieved information 248'''a. The number of bits D3 to D6 of the output pattern may be equal to the number of bits of the second retrieved information 248'''b.

The comparator 275 may comprise a comparing unit 277 for comparing 550 the second retrieved information 248"'b to the first retrieved information 248'''a transposed by coder 276 using the second coding scheme. The comparing unit 277 may have for each pair of bits B3/D3, B4/D4, B5/D5, B6/D6 an equivalence gate (XNOR gate) to compare in pairs the bits of each of said pair of bits. In other words, the indirect comparing 550 may comprise a comparing of a pattern portion B3 to B6 of the stored second information 248"b to a pattern D3 to D6 of a valid encoding of the stored first information 248"a using the second encoding scheme. Because the pattern portion B3 to B6 of the stored first information 248"a is employed for selecting the pattern D3 to D6 and thus the pattern portion B3 to B6 is indirectly used for the comparing, this comparing may be deemed as an indirect comparison 550 of a pattern comprising first 248'''a and second 248"'b retrieved information to a set of valid patterns, considering the result.

The equivalence gates may provide at their outputs comparison result bits E3 to E6. The comparison result bits E3 to E6 may be fed to a NAND gate which delivers a logical 'True' at its output line F when a comparison of any of the pairs of bits failed, and which delivers a logical 'False' when the comparisons of all pairs of bits succeeded. The comparing unit 277 may have an AND gate for transferring the output of the NAND gate as the match-mismatch signal SM on the match-mismatch signal line 222 when the trigger signal SR indicates a trigger status 59 at the trigger signal input line 254, and for pulling the match-mismatch signal SM on the match-mismatch signal line 222 to a match status when the trigger signal SR indicates a regular operation status 57 at the trigger signal input line 254. There are many ways to construct a comparator having similar behavior. The example comparator 275 of Fig. 6 may be substituted by a comparator having a different internal structure but same black-box behavior as the example comparator 275.

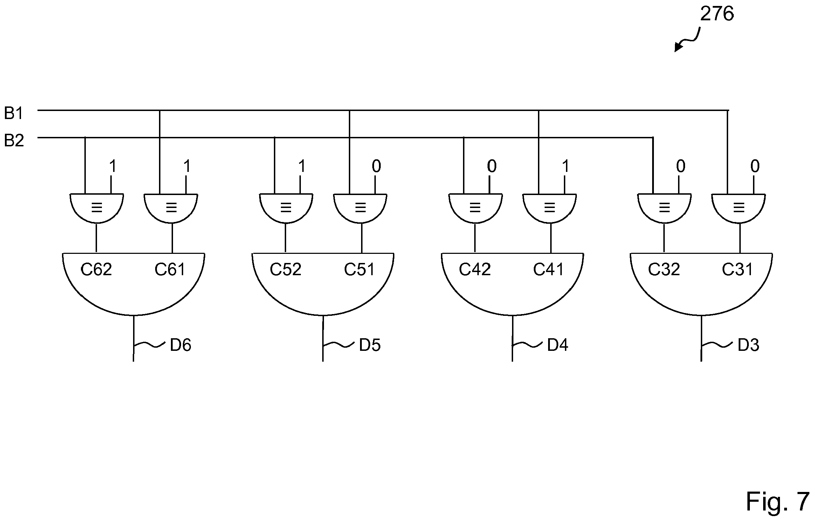

Fig. 7 schematically shows an example embodiment of the coder 276 for encoding a first retrieved information 248'''a using the second coding scheme according to the following table of possible values of the supervised information 248. The input bits B1, B2 may be compared to each possible value of the supervised information 248 by a dedicated comparator for each possible value of the supervised information 248. Results of the bitwise comparisons may be input as bit pairs C31/C32, C41/C42, C51/C52, C61/C62 to AND gates, wherein each of the AND gates may be dedicated to another one of the possible values of the supervised information 248. The set of the output bits of the set of said AND gates may form said output pattern of the coder 276 having bits D3 to D6.

A trigger signal input line 254 of the second comparator 275 may be connected to the trigger signal line 56 of the low-voltage exit detector 100. The second comparator 275 may be constructed to provide a match-mismatch signal SM at the match-mismatch signal line 222 indicating a match.

The second comparator 275 may be constructed to perform the comparison 550 continuously. The match-mismatch signal line 222 indicating a match may be qualified with the trigger status 59.

The second comparator 275 may be constructed to refrain from performing the comparison 550 as long as no trigger signal SR indicating a trigger status 59 is provided at the trigger signal line 56 of the second comparator 275. Refraining from performing the comparison 550 as long as no trigger signal SR indicates the trigger status 59 may allow power saving. In an embodiment, wherein the low-voltage detection of the low-voltage detector 24 and the generation of trigger signal SR by the low-voltage exit detector 100 was more reliable than the retrieving and comparison 550 by the storage checker 210, the refraining from performing the comparison 550 as long as no trigger signal SR indicates the trigger status 59 may allow safer operation of the error detector 200 or of the low-voltage safe controller 400, respectively.

In an embodiment, wherein the low-voltage detection of the low-voltage detector 24 and the generation of trigger signal SR by the low-voltage exit detector 100 was less reliable than the retrieving and comparison 550 by the storage checker 210 a continuous performing of the comparison 550 may allow safer operation of the error detector 200 or of the low-voltage safe controller 400, respectively, than an operation preventing an output of the result of the comparison 550 as long as no trigger signal SR indicates the trigger status 59.

The second comparator 275 for performing the comparison 550 may be a fully combinatorial unit (comprising no storage elements, no flipflops, and no state machine) as shown in Fig. 5 or 6. Comprising no flipflops and comprising no state machine may have the benefit that the second comparator 275 may comprise no storage elements, that could be itself affected by a dropping 63 of the absolute value |Us| of the watched voltage Us. The second comparator 275 may identify an invalid concatenated bit pattern within the information 248"a, 248"b stored in the first 244a and second 244b storage elements. Here, the term 'concatenated bit pattern' designates a bit pattern formed by appending the bit pattern 248"b stored in the second storage element 244b to the bit pattern 248"a stored in the first storage element 244a. The second comparator 275 may perform the identification of the invalid concatenated bit pattern upon reception of a trigger signal SR indicating the trigger status 59.

In an example embodiment, the supervised information 248 may allow four valid states, which are encoded in an information word that consists of 2 Bits ('00', '01', '10', '11'). Two flipflops of the first 244a storage element may be used to store the value of the supervised information 248 directly without further encoding into the first 244a storage element. To store the same value of supervised information 248 in the second storage element 244b four flipflops may be employed using a one-hot coding scheme. The corresponding four values may be coded using the codewords '0001', '0010', '0100', '1000', respectively. The coding scheme is summarized in following Table 1:

| | Supervised information | First loading coding | Second loading coding |
|---|---|---|---|
| Ref.No | 248 | 248'a | 248'b |
| Valid pattern 1 | 00 | 00 | 0001 |
| Valid pattern 2 | 01 | 01 | 0010 |
| Valid pattern 3 | 10 | 10 | 0100 |
| Valid pattern 4 | 11 | 11 | 1000 |

Many different coding schemes can be used, using different numbers of bits, and with an arbitrary amount of valid patterns. Any amount of valid patterns can be supported using a complete encoding (as shown in the previous table for the first coding) or a partial encoding (which could be used for a smaller numbers of valid patterns) by such schemes. The person skilled in the art knows how to define or select the coding schemes, the amount of used storage elements and the amount of valid patterns. The two used coding schemes of the same information may be different for any valid pattern. The example embodiment is one of the possible implementations for four valid patterns.

With the example embodiment, when combining both encodings 248"a and 248"b, we use a 6 bit value to store four permitted valid encoded information patterns. Fig. 6 schematically shows an example embodiment of a comparator 275 for indirectly comparing 550 a pattern comprising a first 248"a and a second 248"b stored information to a set of valid patterns. Fig. 7 schematically shows an example embodiment of a coder 276 for encoding a first retrieved information 248"'a using a second coding.

| | First stored coding (encoding1[1:0]) | Second stored coding (encoding2[3:0]) | SM (valid_ config) |
|---|---|---|---|
| Ref.No | 248'a | 248'b | SM |
| Valid pattern 1 | 00 | 0001 | Valid |
| | 00 | any of: 0000, 0010, 0011, 0100, 0101, 0110, 0111, 1000, 1001, 1010, 1011, 1100, 1101, 1110, 1111 | Invalid |
| Valid pattern 2 | 01 | 0010 | Valid |
| | 01 | any of: 0000, 0001, 0011, 0100, 0101, 0110, 0111, 1000, 1001, 1010, 1011, 1100, 1101, 1110, 1111 | Invalid |
| Valid pattern 3 | 10 | 0100 | Valid |
| | 10 | any of: 0000, 0001, 0010, 0011, 0101, 0110, 0111, 1000, 1001, 1010, 1011, 1100, 1101, 1110, 1111 | Invalid |
| Valid pattern 4 | 11 | 1000 | Valid |
| | 11 | any of: 0000, 0001, 0010, 0011, 0100, 0101, 0110, 0111, 1001, 1010, 1011,1100,1101,1110,1111 | Invalid |

With this example embodiment, in total 6 Bits are used for storing a 2 bit value allowing up to four valid patterns. In an alternative example embodiment the valid codewords for the second encoding may be '0011', '0110', '1100', '1001'. In both example embodiments, the amount of invalid patterns may be 93,75% (= 100% - 2²/2⁶). In an example embodiment, a ratio of a number of valid information patterns divided by a number of possible concatenated bit patterns of both storage elements 244a, 244b may be less than 15 %, in particular less than 0.1ⁿ % (= (0.1 to the power of n)/100) for at least one of the values 0, 1, 2, 3, 4, 5, 6, 7, 8, 9, or 10. The ratio of valid bit patterns to the bits used to encode the valid information basically allows any possible ratio desired to achieve the requested safety. Due to comparison 550 with the valid set of patterns, any invalid pattern of the stored information 248"a, 248"b which can result from a brown-out condition can be detected. Nevertheless, it is still possible that the stored information 248"a, 248"b switches from one valid into another valid pattern as a result of a real brown-out condition 65.

A probability that such an inadvertent modification (valid to another, but wrong valid pattern) of the values of the stored information 248"a, 248"b stored in the first 244a and second 244b storage elements will be noticed may be increased, if the storage elements 244a, 244b used typically tend to assume only a subset of one of the possible states under real brown-out conditions 65, and if only a minimum of or no valid concatenated bit pattern belongs to this subset. A further concept for increasing a probability that an inadvertent modification of the values of the stored information 248"a, 248"b will be noticed may be to chose for the first and second coding a coding having a maximal Hamming distance to bit patterns which the set of flipflops Fn to F1 typically tends to assume under real brown-out conditions 65.

In the example embodiment, the most probable states of the flipflops used for the storage elements after a real brown-out condition 65 is either '000000' (all Bit Zero) or '111111' (all Bit Ones), when the same flipflop type is used for all storage elements. A real brown-out condition 65 can be reliably identified if the resulting bit pattern formed none of the valid bit patterns of the loading information 248'a, 248'b. In the example embodiment, this is the case, because each of the valid bit patterns has simultaneously at least one Zero and at least one One. None of the typical states '000000' or '111111' fulfills this requirement.

The error detector 200 may comprise a second comparator 275 for comparing 550 information 248"a combined with second information 248"b against the set of valid patterns 249 and capable of generating a match-mismatch signal SM. The second coding scheme may be different from the first coding scheme. The existence of a difference of both coding schemes may have the benefit that in case of a brown-out the first 248"a and second 248"b stored information are changed such that the meaning of the fist stored information 248"a is different to the meaning of the second stored information 248"b. In other words: A first decoding of thought of the first stored information 248"a using the first coding scheme and a second decoding of thought of the second stored information 248"b using the second coding scheme deliver different decoding results of thought. Any invalid state of the stored information 248"a, 248"b may then be detected and reported by the signal SM.

In an example embodiment the error detector 200 may comprise a first retriever 270a for retrieving 540a stored information 248"a stored in the first storage element 244a and a second retriever 270b for retrieving 540b stored information 248"b stored in the second storage element 244b. A further, alternative example embodiment of the second comparator 275 may comprise a comparison 550 of the retrieved information 248"'a that may be retrieved and decoded by the first retriever 270a with the retrieved information 248"'b that may be retrieved and decoded by the second retriever 270b.

In other words: The first retriever 540a may comprise a first decoder for decoding the first stored information 248"a fetched from the first storage element 244a. The second retriever 540b may comprise a second decoder for decoding the second stored information 248"b fetched from the second storage element 244b. The second coding scheme may be different from the first coding scheme. At least one of the first coding scheme and the second coding scheme may be a neutral operation on the supervised information 248. The set of valid patterns may comprise for each possible value of the supervised information 248 a pattern comprising a first loading information 248'a and a second loading information 248'b, wherein for each of said patterns the first loading information 248'a is a respective value of the supervised information 248 coded using the first coding scheme, and wherein for each of said patterns the second loading information 248'b is a respective value of the supervised information 248 coded using the second coding scheme. The comparator 275 may comprise at least one of a coder 276 for encoding the first retrieved information 248"'a using the second coding scheme and a coder for encoding the second retrieved information 248"'b using the first coding scheme.

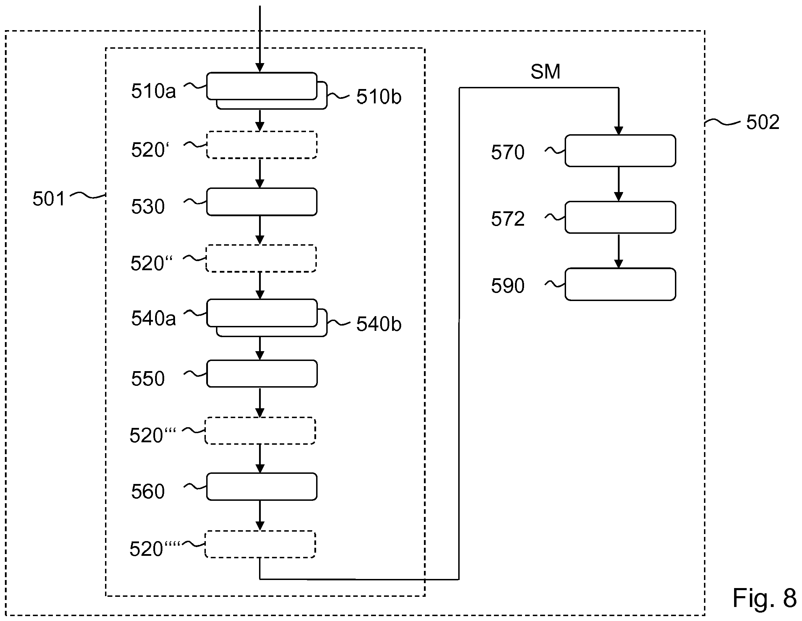

A brown-out detection method 501 (see Fig. 8) may comprise the steps of: loading 510a information 248'a into a first storage element 244a, wherein the information 248'a is the supervised information 248 coded by a first coding scheme; loading 510b information 248'b into a second storage element 244b, wherein the information 248'b is the supervised information 248 coded by a second coding scheme; receiving 520 a trigger signal SR from a low-voltage exit detector 100; retrieving 540a stored information 248"a stored in the first storage element 244a; retrieving 540b stored information 248"b stored in the second storage element 244b. The loading 510a and the loading 510b may be performed simultaneously or sequentially in any order. The retrieving 540a and the retrieving 540b may be performed simultaneously or sequentially in any order.

The error detector 200 may comprise a load/reload request signal line 287 for providing a load request signal SH for enabling the loading 510a by the first loader 255a to load the loading information 248'a (after optionally having encoded it) into the information storage 244a, and for enabling the second loader 255b to load the loading information 248'b (after optionally having encoded it) into the information storage 244b. Alternatively, the load request signal SH can be used to enable/disable a hold functionality 520' or to implement a storage function 530 which may be implemented by the storage elements 244a, 244b.

The error detector 200 may comprise a trigger signal line 56 for receiving 520 a trigger signal SR from the low-voltage exit detector 100 and at least one of a trigger function 520" for enabling the retrieval of the stored information 248"a, 248"b, a trigger function 520''' for controlling 550 a generation of an comparison result or a enable/disable function 520'''' for enabling/disabling the provision of the match-mismatch signal SM.

In an example embodiment the brown-out detection method 501 may comprise a step 550 of comparing a meaning of the retrieved information 248"'a retrieved from the first storage element 244a to a meaning of the retrieved information 248'''bretrieved from the second storage element 244b; providing 560 a match-mismatch signal SM indicating a mismatch when there is a mismatch with each pattern of the valid patterns of the set of valid patterns, and providing a match-mismatch signal SM indicating a match when there is a match with at least one pattern of the valid patterns of the set of valid patterns.

The brown-out detection method 501 may further comprise the steps of: controlling 530 a generation or an output of the match-mismatch signal SM indicating the match, wherein the generation or the output, respectively, is dependent on the receiving 520 of the trigger signal SR from a low-voltage exit detector 100. The trigger signal SR may be used for at least one of a triggering of the retrieval, of a triggering of the comparison 550, and of a triggering of the delivery of the match/mismatch signal SM.

A synchronizer 283 may be employed to transfer the match-mismatch signal SM to a match-mismatch signal input 286 of a correcting unit 285. Triggered by the match-mismatch signal SM, the synchronizer 283 may synchronize or resynchronize the possibly glitchy match-mismatch signal SM and may generate a properly synchronized correction request SC.

The correcting unit 285 may comprise a load/reload request line 287, transferring the reload request signal SH to a first loader 255a for loading 510a a first loading information 248'a into a first storage element 244a, wherein the information 248 is coded using a first coding scheme; a second loader 255b for loading 510b a second loading information 248'b into a second storage element 244b, wherein the supervised information 248 is coded using a second coding scheme. Alternatively the reload request signal SH may be used to inform the storage elements 244a and 244b to use a default, valid configuration to repair an invalid configuration which resulted from a real brown-out condition 65.

The first loader 255a may be constructed to load 510a the first loading information 248'a derived from an information source 230 into the first storage element 244a. The first loader 255a may comprise an encoder for encoding the supervised information 248 before loading 510a the coded first loading information 248'a into the first storage element 244a.

The second loader 255b may be constructed to load 510b the second loading information 248'b derived from the information source 230 into the second storage element 244b. The second loader 255b may comprise an encoder for encoding the supervised information 248 before loading 510b the second loading information 248'b into the second storage element 244b.

The correcting unit 285 may further comprise a notification line 289 for notifying 590 the application unit 20 about at least one of a low-voltage exit status 64 and a correction request SC. Upon reception of the correction request SC, the correcting unit 285 may assert related data switches back to reset, default, or another bit pattern that is valid and matches application or system-on-chip needs. Another option besides a reset/default value might be the reload of the data from another source.

In other words, the brown-out detection method 501 may comprise at least one of the steps of loading 510a first loading information 248'a into a first storage element 244a, wherein the first loading information 248'a is a supervised information 248 coded using a first coding scheme; loading 510b second loading information 248'b into a second storage element 244b, wherein the second loading information 248'b is the supervised information 248 coded using a second coding scheme; receiving 520 a trigger signal SR from a low-voltage exit detector 100; retrieving 540a first stored information 248"a stored in the first storage element 244a; retrieving 540b second stored information 248"b stored in the second storage element 244b; comparing 550 a combination of a first retrieved information 248"'a retrieved from the first storage element 244a and second retrieved information 248"'b retrieved from the second storage element 244b to each pattern of a set of valid patterns; and providing 560 a match-mismatch signal SM indicating a mismatch when the combination of the first retrieved information 248"'a and the second retrieved information 248"'b does not match to any of the patterns of the set of valid patterns, and providing a match-mismatch signal SM indicating a match when the combination of the first retrieved information 248"'a and the second retrieved information 248"'b matches any of the patterns of the set of valid patterns. A brown-out self-healing method 502 may comprise: the steps of brown-out detection method 501 described above; performing at least one of the steps of: identifying 550, 560 that stored information 248"a, 248"b stored in at least one of the first 244a and second 244b storage elements is incorrect 570; and correcting the content of these storage elements 244a, 244b by a reset 572, setting a default 572, or reloading 572 this data or using another bit pattern that matches application or system-on-chip needs. The brown-out self-healing method 502 may further comprise a step of notifying 590 an application unit 20 about at least one of a reception of the trigger signal SR, a provision of a match-mismatch signal SM 570, and a correcting operation 572 of stored information 248"a, 248"b. The correcting operation 572 may comprise a reset, a reload of the correct value from a secondary source, or an application of a default mode, or of another valid bit pattern.

In harsh environments, for example automotive applications, there may be large voltage swings on power lines. With conventional low-voltage surveillance, each low-voltage event may cause a device reset. Generally, such hardware resets are undesirable, because they may prevent an application from further processing, even from handling alarms. A device reset may result in a full application initialization cycle.

The error detector 200 according to the present invention may avoid a necessity of a portion of resets, without waving any surveillance. The described error detector 200 may distinguish two types of low-voltage events 62, 63. The first type of low-voltage event 62 requires no special action except performing a storage check 540a, 540b, 550, because the existence of an affect of the low-voltage event to the integrity of stored information 248"a, 248"b like control data or application data can be excluded by the storage check 540a, 540b, 550. The second type of low-voltage events 63 requires special action 572 when resulting in an invalid configuration. Further activities may be requested by the application 20 triggered by the notification SN. The required special action may be a correction 572 of stored information 248"a, 248"b stored in at least one of the first and second storage elements 244a, 244b. The error detector may detect real brown-out events 65 that affect all or specific logic. The low-voltage exit detector 100 may identify whether the absolute value |Us| of the watched voltage Us has left a low-voltage condition 62, 63. Then, the error detector 200 may identify a possible misconfiguration (i.e. an invalid bit pattern 248"a, 248"b) of the storage elements 244a, 244b for storing the loading information 248'a, 248'b. When the detector has identified a misconfiguration 570 of the storage elements 244a, 244b used for storing the loading information 248'a, 248'b, the error detector 200 may generate a match-mismatch signal SM indicating a mismatch. The match-mismatch signal SM may be employed for initiating a correction activity 572, which may be called self-healing activity. The self-healing activity 572 may comprise a re-loading or an execution of a reset.

When applying conventional design rules for defining the value of the threshold value Uth, the low-voltage detector 24 may always issue a warning signal 29 before the absolute value |Us| of the watched voltage Us drops below the 0.95 V; that is, before there may be any risk at all that the application unit 20 may work incorrectly. With the present invention each real brown-out 65 of the stored information 248"a, 248"b can be reliably identified and the validity of the stored information 248"a, 248"b may be constantly asserted to have a value of the valid set of patterns. Because each real brown-out 65 can be reliably identified with the present invention, a large portion of low-voltage events 62, 63 anyway triggering the low-voltage detector 24 (potential brown-out conditions) may be "suppressed" from causing an unfavorable reset command to the application unit 20. This may improve the availability of a system using the first stored information 248"a or being indirectly dependent on correctness of the first stored information 248"a. Availability is for example generally of high importance for safety in automotive systems. For example, an unexpected switching-off of an electrical power steering system or electrical brake system may cause serious accidents.

Following further measures for avoiding an inadvertent modification of the stored information 248"a, 248"b by a low-voltage event 62, 63 may be employed. For the first 244a and second 244b storage element the same flipflop type may be selected which has an optimal retention behavior. Avoiding of unnecessary clocking may minimize a probability of an impact on the content of flipflops keeping the stored information 248"a, 248"b, making them only dependent on static data retention instead of having to shield them from clock glitches, instable data inputs or similar events. By applying at least one of the measures, a probability may be increased that functions of the application 20 are affected by a dropping 62, 63 of the absolute value |Us| of the watched voltage Us before the stored information 248"a, 248"b was affected. In an alternative embodiment, by applying at least one the measures a probability may be increased that the stored information 248"a, 248"b is affected by a dropping 62, 63 of the watched voltage before functions of the application 20 were affected. The alternative approach can make sense when the application had no sufficient own brown-out robustness.

In the foregoing specification, the invention has been described with reference to specific examples of embodiments of the invention. It will, however, be evident that various modifications and changes may be made therein without departing from the invention as set forth in the appended claims.

The connections as discussed herein may be any type of connection suitable to transfer signals from or to the respective nodes, units or devices, for example via intermediate devices. Accordingly, unless implied or stated otherwise, the connections may for example be direct connections or indirect connections. The connections may be illustrated or described in reference to being a single connection, a plurality of connections, unidirectional connections, or bidirectional connections. However, different embodiments may vary the implementation of the connections. For example, separate unidirectional connections may be used rather than bidirectional connections and vice versa. Also, plurality of connections may be replaced with a single connection that transfers multiple signals serially or in a time multiplexed manner. Likewise, single connections carrying multiple signals may be separated out into various different connections carrying subsets of these signals. Therefore, many options exist for transferring signals.

Although specific conductivity types or polarity of potentials have been described in the examples, it will be appreciated that conductivity types and polarities of potentials may be reversed.

Each signal described herein may be designed as positive or negative logic. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals.

Those skilled in the art will recognize that the boundaries between logic blocks are merely illustrative and that alternative embodiments may merge logic blocks or circuit elements or impose an alternate decomposition of functionality upon various logic blocks or circuit elements. Thus, it is to be understood that the architectures depicted herein are merely exemplary, and that in fact many other architectures can be implemented which achieve the same functionality. For example, the sensing section may be seen as being separate from the sensing arrangement switching device, or they may be components of a common circuitry. An analogous statement holds for the storage section and the storage arrangement switching device. For the transistors, any kind of suitable transistor may be utilized. A transistor e.g. may be a bipolar junction transistor, a field effect transistor, a MOSFET (metal-oxide-semiconductor field-effect transistor), JFET (junction gate field-effect transistor) or any other kind of transistor. For different transistors, different types of transistors may be utilized. For example, the type of transistor used for one of the transistors of the input differential pair may be different from the type of transistor used for the gate transistors.

Any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermediate components. Likewise, any two components so associated can also be viewed as being "operably connected," or "operably coupled," to each other to achieve the desired functionality.

Furthermore, those skilled in the art will recognize that boundaries between the above described operations merely illustrative. The multiple operations may be combined into a single operation, a single operation may be distributed in additional operations and operations may be executed at least partially overlapping in time. Moreover, alternative embodiments may include multiple instances of a particular operation, and the order of operations may be altered in various other embodiments.

Also for example, in one embodiment, the illustrated examples may be implemented as circuitry located on a single integrated circuit or within a same device. For example, the transistors respectively the latch circuits may be implemented on a common substrate. Alternatively, the examples may be implemented as any number of separate integrated circuits or separate devices interconnected with each other in a suitable manner. For example, each latch circuit may be implemented as individual module, wherein the modules may be interconnected. Also for example, the examples, or portions thereof, may implemented as soft or code representations of physical circuitry or of logical representations convertible into physical circuitry, such as in a hardware description language of any appropriate type.

The semiconductor substrate described herein can be any semiconductor material or combinations of materials, such as gallium arsenide, silicon germanium, silicon-on-insulator (SOI), silicon, monocrystalline silicon, the like, and combinations of the above.

In the foregoing specification, the invention has been described with reference to specific examples of embodiments of the invention. It will, however, be evident that various modifications and changes may be made therein without departing from the invention as set forth in the appended claims.

However, other modifications, variations and alternatives are also possible. The specifications and drawings are, accordingly, to be regarded in an illustrative rather than in a restrictive sense.

In the claims, any reference signs placed between parentheses shall not be construed as limiting the claim. The word 'comprising' does not exclude the presence of other elements or steps then those listed in a claim. Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements. The mere fact that certain measures are recited in mutually different claims does not indicate that a combination of these measures cannot be used to advantage.

## Claims

1. An error detector (200) for detecting storage errors, wherein the error detector (200) comprises:
- a low-voltage exit detector (100) including:
- a low-voltage detector (24) for detecting a non-low-voltage condition (61) of a watched voltage (Us), in which an absolute value (|Us|) of the watched voltage (Us) is higher than a threshold voltage (Uth), and for detecting a low-voltage condition (62, 63) of the watched voltage (Us), in which the absolute value (|Us|) is lower than the threshold voltage (Uth); and
- a voltage rise detector (50) for providing a trigger signal (SR) upon detection of a change (78) from the low-voltage condition (62, 63) of the watched voltage (Us) to a non-low-voltage condition (61) of the watched voltage (Us).
- a first loader (255a) for loading (510a) a first loading information (248'a) into a first storage element (244a), wherein the first loading information (248'a) is a supervised information (248) coded using a first coding scheme;
- a second loader (255b) for loading (510b) a second loading information (248'b) into a second storage element (244b), wherein the second loading information (248'b) is the supervised information (248) coded using a second coding scheme;
- a first retriever (270a) for retrieving (540a) a first stored information (248"a) stored in the first storage element (244a);
- a second retriever (270b) for retrieving (540b) a second stored information (248"b) stored in the second storage element (244b);
- a comparator (275) for comparing (550) a combination of a first retrieved information (248"'a) retrieved using the first retriever (270a) and a second retrieved information (248"'b) retrieved using the second retriever (270b) to each encoding pattern of a set of valid patterns and for generating a match-mismatch signal (SM) indicating a result of this comparison (550); and
- a trigger signal line (56) for receiving a trigger signal (SR) from a low-voltage exit detector (100) and at least one of a trigger function (520") for enabling the retrieval of the retrieved information (248'''a, 248"'b), a trigger function (520''') for controlling a generation (550) of a comparison result, and an enable function (520"") for enabling an output of the match-mismatch signal (SM) only in case of receiving the trigger signal (SR) from the low-voltage exit detector (100).

2. The error detector (200) according to claim 1, wherein at least one of following applies:
- the first retriever (540a) comprises a first decoder for decoding the first stored information (248"a) fetched from in the first storage element (244a);
- the second retriever (540b) comprises a second decoder for decoding the second stored information (248"b) fetched from the second storage element (244b);
- the second coding scheme is different from the first coding scheme;
- at least one of the first coding scheme and the second coding scheme is a neutral operation on the supervised information (248);
- the set of valid patterns comprises for each possible value of the supervised information (248) a pattern comprising a first loading information (248'a) and a second loading information (248'b), wherein for each of said patterns the first loading information (248'a) is a respective value of the supervised information (248) coded using the first coding scheme, and wherein for each of said patterns the second loading information (248'b) is a respective value of the supervised information (248) coded using the second coding scheme;
- the comparator (275) comprises at least one of a coder (276) for encoding the first retrieved information (248'''a) using the second coding scheme and a coder for encoding the second retrieved information (248"'b) using the first coding scheme.

3. The error detector (200) according to claim 1 or 2, wherein the comparator (275) is constructed for performing the comparison (550) fully combinatorial and without employing a state machine.

4. The error detector (200) according to one of claims 1 to 3, wherein the error detector (200) further comprises a corrector (285) for performing a correction (572) of stored information (248"a, 248"b) stored in at least one of the first (244a) and the second (244b) storage elements upon detecting an invalid configuration (570).

5. The error detector (200) according to one of claims 1 to 4, wherein a ratio of a number of valid bit patterns of the first storage element (244a) divided by a number of possible concatenated bit patterns of both storage elements (244a, 244b) is less than 15 %, in particular less than 0.1ⁿ %, i.e. 0.1 to the power of n, then divided by 100, for at least one of the values n = 0, 1, 2, 3, 4, 5, 6, 7, 8, 9, or 10.

6. The error detector (200) according to one of claims 1 to 5, wherein the voltage rise detector (50) comprises at least one of an asynchronous and a synchronous shift register (FFn, ..., FF1) having at least two shift stages (FFn, ..., FF1).

7. The error detector (200) according to claim 6, wherein the low-voltage detector (24) has a warning signal line (26) for providing a warning signal (SW), wherein flipflops (FFn, ..., FF1) of the at least one shift register (FFn, ..., FF1) have preset terminals (166), wherein the preset terminals are connected to the warning signal line (26), wherein each of the preset terminals is either a reset terminal or a set terminal.

8. The error detector (200) according to one of claims 1 to 7, wherein the voltage rise detector (50) comprises a duration assertion device (51) for asserting a duration of a period (75), in which the non-low-voltage condition (61) of a watched voltage (Us) has not changed (78) to the low-voltage condition (62, 63) since a last change (78) from the low-voltage condition (62, 63) to the non-low-voltage condition (61).

9. A low-voltage safe controller (400) comprising an error detector (200) according to one of claims 1 to 8 and an application unit (20).

10. A brown-out detection method (501) performed at an error detector (200) according to one of the claims 1 to 9, the method comprising the steps of:
- loading (510a) said first loading information (248'a) into said first storage element (244a), wherein the first loading information (248'a) is said supervised information (248) coded using said first coding scheme;
- loading (510b) said second loading information (248'b) into said second storage element (244b), wherein the second loading information (248'b) is the supervised information (248) coded using said second coding scheme;
- receiving (520) said trigger signal (SR) from said low-voltage exit detector (100) of the error detector (200);
- retrieving (540a) said first stored information (248"a) stored in the first storage element (244a);
- retrieving (540b) said second stored information (248"b) stored in the second storage element (244b);
- comparing (550) said combination of said first retrieved information (248"'a) retrieved from the first storage element (244a) and said second retrieved information (248"'b) retrieved from the second storage element (244b) to each encoding pattern of said set of valid patterns;
- providing (560) said match-mismatch signal (SM) indicating said mismatch when the combination of the first retrieved information (248'''a) and the second retrieved information (248"'b) does not match any of the patterns of the set of valid patterns, and providing said match-mismatch signal (SM) indicating said match when the combination of the first retrieved information (248'''a) and the second retrieved information (248"'b) matches any of the patterns of the set of valid patterns; and
- controlling (530) said generation of the match-mismatch signal (SM) indicating the match, wherein the generation is dependent on the receiving (520) of the trigger signal (SR) from said low-voltage exit detector (100), or controlling (530) said output of the match-mismatch signal (SM) indicating the match, wherein the output is dependent on the receiving (520) of the trigger signal (SR) from said low-voltage exit detector (100).

11. A brown-out self-healing method (502) comprising:
- the steps of the brown-out detection method (501) according to claim 10;
- performing at least one of the steps of:
identifying (570) invalid content in the stored information (248"a, 248"b) stored in at least one of the first (244a) and second (244b) storage elements; and
switching back (572) to a reset, a default, or another bit pattern (248'a, 248'b) that matches application or system-on-chip needs.

## Patentansprüche

1. Fehlerdetektor (200) zum Erkennen von Speicherfehlern, wobei der Fehlerdetektor (200) Folgendes umfasst:
- einen Niederspannungs-Ausgangsdetektor (100), der Folgendes aufweist:
- einen Niederspannungsdetektor (24) zum Erkennen eines Nicht-Niederspannungszustands (61) einer überwachten Spannung (Us), bei dem ein Absolutwert (|Us|) der überwachten Spannung (Us) höher als eine Schwellenspannung (Uth) ist, und zum Erkennen eines Niederspannungszustands (62, 63) der überwachten Spannung (Us), bei dem der Absolutwert (|Us|) niedriger als die Schwellenspannung (Uth) ist; und
- einen Spannungsanstiegsdetektor (50) zum Bereitstellen eines Triggersignals (SR) bei Erkennen eines Wechsels (78) von dem Niederspannungszustand (62, 63) der überwachten Spannung (Us) zu einem Nicht-Niederspannungszustand (61) der überwachten Spannung (Us) ;
- einen ersten Lader (255a) zum Laden (510a) einer ersten Ladeinformation (248'a) in ein erstes Speicherelement (244a), wobei die erste Ladeinformation (248'a) eine überwachte Information (248) ist, die unter Verwendung eines ersten Codierungsschemas codiert ist;
- einen zweiten Lader (255b) zum Laden (510b) einer zweiten Ladeinformation (248'b) in ein zweites Speicherelement (244b), wobei die zweite Ladeinformation (248'b) die überwachte Information (248) ist, die unter Verwendung eines zweiten Codierungsschemas codiert ist;
- einen ersten Abrufer (270a) zum Abrufen (540a) einer ersten gespeicherten Information (248"a), die in dem ersten Speicherelement (244a) gespeichert ist;
- einen zweiten Abrufer (270b) zum Abrufen (540b) einer zweiten gespeicherten Information (248"b), die in dem zweiten Speicherelement (244b) gespeichert ist;
- einen Komparator (275) zum Vergleichen (550) einer Kombination einer ersten abgerufenen Information (248"'a), die unter Verwendung des ersten Abrufers (270a) abgerufen wurde, und einer zweiten abgerufenen Information (248"'b), die unter Verwendung des zweiten Abrufers (270b) abgerufen wurde, mit jedem Codierungsmuster eines Satzes gültiger Muster und zum Erzeugen eines Übereinstimmungs-Nichtübereinstimmungs-Signals (SM), das ein Ergebnis dieses Vergleichs (550) angibt; und
- eine Triggersignalleitung (56) zum Empfangen eines Triggersignals (SR) von einem Niederspannungs-Ausgangsdetektor (100) und mindestens eine von einer Triggerfunktion (520") zum Aktivieren des Abrufs der abgerufenen Informationen (248"'a, 248"'b), einer Triggerfunktion (520"') zum Steuern einer Erzeugung (550) eines Vergleichsergebnisses und einer Aktivierungsfunktion (520"") zum Aktivieren einer Ausgabe des Übereinstimmungs-Nichtübereinstimmungs-Signals (SM) nur in dem Fall, dass das Triggersignal (SR) von dem Niederspannungs-Ausgangsdetektor (100) empfangen wird.

2. Fehlerdetektor (200) gemäß Anspruch 1, wobei mindestens einer der folgenden Punkte gilt:
- der erste Abrufer (540a) weist einen ersten Decoder zum Decodieren der ersten gespeicherten Information (248"a) auf, die aus dem ersten Speicherelement (244a) geholt wurde;
- der zweite Abrufer (540b) weist einen zweiten Decoder zum Decodieren der zweiten gespeicherten Information (248"b) auf, die von dem zweiten Speicherelement (244b) geholt wurde;
- das zweite Codierungsschema unterscheidet sich von dem ersten Codierungsschema;
- mindestens eines des ersten Codierungsschemas und des zweiten Codierungsschemas ist eine neutrale Operation an der überwachten Information (248);
- der Satz gültiger Muster umfasst für jeden möglichen Wert der überwachten Information (248) ein Muster, das eine erste Ladeinformation (248'a) und eine zweite Ladeinformation (248'b) aufweist, wobei für jedes der Muster die erste Ladeinformation (248'a) ein jeweiliger Wert der überwachten Information (248) ist, die unter Verwendung des ersten Codierungsschemas codiert ist, und wobei für jedes der Muster die zweite Ladeinformation (248'b) ein jeweiliger Wert der überwachten Information (248) ist, die unter Verwendung des zweiten Codierungsschemas codiert ist;
- der Komparator (275) umfasst mindestens einen von einem Codierer (276) zum Codieren der ersten abgerufenen Information (248"'a) unter Verwendung des zweiten Codierungsschemas und einen Codierer zum Codieren der zweiten abgerufenen Information (248"'b) unter Verwendung des ersten Codierungsschemas.

3. Fehlerdetektor (200) gemäß Anspruch 1 oder 2, wobei der Komparator (275) zur Durchführung des Vergleichs (550) vollständig kombinatorisch und ohne Verwendung einer Zustandsmaschine aufgebaut ist.

4. Fehlerdetektor (200) gemäß einem der Ansprüche 1 bis 3, wobei der Fehlerdetektor (200) ferner einen Korrektor (285) zum Durchführen einer Korrektur (572) gespeicherter Informationen (248"a, 248"b) umfasst, die beim Erkennen einer ungültigen Konfiguration (570) in mindestens einem der ersten (244a) und zweiten (244b) Speicherelemente gespeichert sind.

5. Fehlerdetektor (200) gemäß einem der Ansprüche 1 bis 4, wobei ein Verhältnis einer Anzahl gültiger Bitmuster des ersten Speicherelements (244a) dividiert durch eine Anzahl möglicher verketteter Bitmuster beider Speicherelemente (244a, 244b) kleiner als 15 %, insbesondere kleiner als 0,1ⁿ %, d. h. 0,1 hoch n, dann geteilt durch 100, für mindestens einen der Werte n = 0, 1, 2, 3, 4, 5, 6, 7, 8, 9 oder 10 ist.

6. Fehlerdetektor (200) gemäß einem der Ansprüche 1 bis 5, wobei der Spannungsanstiegsdetektor (50) mindestens eines von einem asynchronen und einem synchronen Schieberegister (FFn, ..., FF1) mit mindestens zwei Schiebestufen (FFn, ..., FF1) aufweist.

7. Fehlerdetektor (200) gemäß Anspruch 6, wobei der Niederspannungsdetektor (24) eine Warnsignalleitung (26) zum Bereitstellen eines Warnsignals (SW) aufweist, wobei Flip-Flops (FFn, ..., FF1) des mindestens einen Schieberegisters (FFn, ..., FF1) Voreinstellungsanschlüsse (166) aufweisen, wobei die Voreinstellungsanschlüsse mit der Warnsignalleitung (26) verbunden sind, wobei jeder der Voreinstellungsanschlüsse entweder ein Rücksetzanschluss oder ein Einstellanschluss ist.

8. Fehlerdetektor (200) gemäß einem der Ansprüche 1 bis 7, wobei der Spannungsanstiegsdetektor (50) eine Dauerbestätigungsvorrichtung (51) zum Bestätigen einer Dauer eines Zeitraums (75) aufweist, in dem der Nicht-Niederspannungszustand (61) einer überwachten Spannung (Us) seit einem letzten Wechsel (78) vom Niederspannungszustand (62, 63) in den Nicht-Niederspannungszustand (61) nicht in den Niederspannungszustand (62, 63) gewechselt (78) hat.

9. Niederspannungs-Sicherheitscontroller (400), der einen Fehlerdetektor (200) gemäß einem der Ansprüche 1 bis 8 und eine Anwendungseinheit (20) umfasst.

10. Brownout-Erkennungsverfahren (501), durchgeführt an einem Fehlerdetektor (200) gemäß einem der Ansprüche 1 bis 9, wobei das Verfahren die folgenden Schritte aufweist:
- Laden (510a) der ersten Ladeinformation (248'a) in das erste Speicherelement (244a),
wobei die erste Ladeinformation (248'a) die überwachte Information (248) ist, die unter Verwendung des ersten Codierungsschemas codiert ist;
- Laden (510b) der zweiten Ladeinformation (248'b) in das zweite Speicherelement (244b), wobei die zweite Ladeinformation (248'b) die überwachte Information (248) ist, die unter Verwendung des zweiten Codierungsschemas codiert ist;
- Empfangen (520) des Triggersignals (SR) von dem Niederspannungs-Ausgangsdetektor (100) des Fehlerdetektors (200);
- Abrufen (540a) der ersten gespeicherten Information (248"a), die in dem ersten Speicherelement (244a) gespeichert ist;
- Abrufen (540b) der zweiten gespeicherten Information (248"b), die in dem zweiten Speicherelement (244b) gespeichert ist;
- Vergleichen (550) der Kombination der ersten abgerufenen Information (248"'a), die von dem ersten Speicherelement (244a) abgerufen wurde, und der zweiten abgerufenen Information (248"'b), die von dem zweiten Speicherelement (244b) abgerufen wurde, mit jedem Codierungsmuster des Satzes von gültigen Mustern;
- Bereitstellen (560) des Übereinstimmungs-Nichtübereinstimmungs-Signals (SM), das die Nichtübereinstimmung angibt, wenn die Kombination aus der ersten abgerufenen Information (248"'a) und der zweiten abgerufenen Information (248"'b) mit keinem der Muster des Satzes gültiger Muster übereinstimmt, und Bereitstellen des Übereinstimmungs-Nichtübereinstimmungs-Signals (SM), das die Übereinstimmung angibt, wenn die Kombination aus der ersten abgerufenen Information (248"'a) und der zweiten abgerufenen Information (248"'b) mit einem beliebigen der Muster des Satzes gültiger Muster übereinstimmt; und
- Steuern (530) der Erzeugung des Übereinstimmungs-Nichtübereinstimmungs-Signals (SM), das die Übereinstimmung angibt, wobei die Erzeugung von dem Empfangen (520) des Triggersignals (SR) von dem Niederspannungs-Ausgangsdetektor (100) abhängig ist, oder Steuern (530) der Ausgabe des Übereinstimmungs-Nichtübereinstimmungs-Signals (SM), das die Übereinstimmung angibt, wobei die Ausgabe von dem Empfangen (520) des Triggersignals (SR) von dem Niederspannungs-Ausgangsdetektor (100) abhängig ist.

11. Brownout-Selbstheilungsverfahren (502), das Folgendes umfasst:
- die Schritte des Brownout-Erkennungsverfahrens (501) gemäß Anspruch 10;
- Durchführen von mindestens einem der folgenden Schritte:
Identifizieren (570) eines ungültigen Inhalts in den gespeicherten Informationen (248"a, 248"b), die in mindestens einem der ersten (244a) und zweiten (244b) Speicherelemente gespeichert sind; und
Zurückschalten (572) auf einen Reset, eine Voreinstellung oder ein anderes Bitmuster (248'a, 248'b), das den Anforderungen der Anwendung oder des Systems auf einem Chip entspricht.

## Revendications

1. Détecteur d'erreurs (200) destiné à détecter des erreurs de stockage, le détecteur d'erreurs (200) comprenant :
- un détecteur de sortie basse tension (100) comportant :
- un détecteur de basse tension (24) destiné à détecter un état non de basse tension (61) d'une tension surveillée (Us), une valeur absolue (|Us|) de la tension surveillée (Us) étant supérieure à une tension de seuil (Uth), et à détecter un état de basse tension (62, 63) de la tension surveillée (Us), la valeur absolue (|Us|) étant inférieure à la tension de seuil (Uth) ; et
- un détecteur de montée en tension (50) destiné à fournir un signal de déclenchement (SR) lors de la détection d'un changement (78) de l'état de basse tension (62, 63) de la tension surveillée (Us) à un état non de basse tension (61) de la tension surveillée (Us) .
- un premier chargeur (255a) destiné à charger (510a) des premières informations de chargement (248'a) dans un premier élément de stockage (244a), les premières informations de chargement (248'a) étant des informations supervisées (248) codées à l'aide d'un premier mécanisme de codage ;
- un second chargeur (255b) destiné à charger (510b) des secondes informations de chargement (248'b) dans un second élément de stockage (244b), les secondes informations de chargement (248'b) étant les informations supervisées (248) codées à l'aide d'un second mécanisme de codage ;
- un premier outil de récupération (270a) destiné à récupérer (540a) des premières informations stockées (248"a) qui sont stockées dans le premier élément de stockage (244a) ;
- un second outil de récupération (270b) destiné à récupérer (540b) des secondes informations stockées (248"b) qui sont stockées dans le second élément de stockage (244b) ;
- un comparateur (275) destiné à comparer (550) une combinaison de premières informations récupérées (248'''a) qui sont récupérées à l'aide du premier outil de récupération (270a) et de secondes informations récupérées (248'''b) qui sont récupérées à l'aide du second outil de récupération (270b) à chaque motif d'un ensemble de motifs valides et à générer un signal de correspondance-non correspondance (SM) indiquant un résultat de cette comparaison (550) ; et
- une ligne de signal de déclenchement (56) destinée à recevoir un signal de déclenchement (SR) à partir d'un détecteur de sortie basse tension (100) et au moins une fonction de déclenchement (520") permettant la récupération des informations récupérées (248'''a, 248'''b) et/ou une fonction de déclenchement (520''') pour commander une génération (550) d'un résultat de comparaison et/ou une fonction d'activation (520'''') validant une sortie du signal de correspondance-non-correspondance (SM) uniquement dans le cas d'une réception du signal de déclenchement (SR) à partir du détecteur de sortie basse tension (100).

2. Détecteur d'erreurs (200) selon la revendication 1, dans lequel :
- le premier outil de récupération (540a) comprend un premier décodeur destiné à décoder les premières informations stockées (248"a) extraites dans le premier élément de stockage (244a) ; et/ou
- le second outil de récupération (540b) comprend un second décodeur pour décoder les secondes informations stockées (248"b) extraites du second élément de stockage (244b) ; et/ou
- le second mécanisme de codage est différent du premier mécanisme de codage ; et/ou
- au moins un du premier mécanisme de codage et du second mécanisme de codage est une opération neutre sur les informations supervisées (248) ; et/ou
- l'ensemble de motifs valides comprend pour chaque valeur possible des informations supervisées (248) un motif comprenant des premières informations de chargement (248'a) et des secondes informations de chargement (248'b), dans lequel pour chacun desdits motifs les premières informations de chargement (248'a) sont une valeur respective des informations supervisées (248) codées à l'aide du premier mécanisme de codage, et dans lequel pour chacun desdits motifs les secondes informations de chargement (248'b) sont une valeur respective des informations supervisées (248) codées à l'aide du second mécanisme de codage ; et/ou
- le comparateur (275) comprend au moins un codeur (276) destiné à coder les premières informations récupérées (248'''a) à l'aide du second mécanisme de codage et/ou un codeur pour coder les secondes informations récupérées (248'''b) à l'aide du premier mécanisme de codage.

3. Détecteur d'erreurs (200) selon la revendication 1 ou 2, dans lequel le comparateur (275) est construit pour réaliser la comparaison (550) d'une manière entièrement combinatoire et sans employer d'automate fini.

4. Détecteur d'erreurs (200) selon l'une des revendications 1 à 3, le détecteur d'erreurs (200) comprenant en outre un correcteur (285) destiné à réaliser une correction (572) des informations stockées (248"a, 248"b) stockées dans le premier (244a) et/ou le second (244b) élément de stockage lors de la détection d'une configuration non valide (570).

5. Détecteur d'erreurs (200) selon l'une des revendications 1 à 4, dans lequel un rapport d'un nombre de motifs de bits valides du premier élément de stockage (244a) divisé par un nombre de motifs de bits concaténés possibles des deux éléments de stockage (244a, 244b) est inférieur à 15 %, en particulier inférieur à 0,1ⁿ %, c.-à-d. 0,1 à la puissance n, puis divisé par 100, pour au moins une des valeurs n = 0, 1, 2, 3, 4, 5, 6, 7, 8, 9 ou 10.

6. Détecteur d'erreurs (200) selon l'une des revendications 1 à 5, dans lequel le détecteur de montée en tension (50) comprend au moins un registre à décalage asynchrone et/ou un registre à décalage synchrone (FFn, ... FF1) présentant au moins deux étages de décalage (FFn, ..., FF1).

7. Détecteur d'erreurs (200) selon la revendication 6, dans lequel le détecteur de basse tension (24) présente une ligne de signal d'avertissement (26) destinée à fournir un signal d'avertissement (SW), dans lequel des bascules (FFn, ..., FF1) de l'au moins un registre à décalage (FFn, ..., FF1) présentent des bornes prédéfinies (166), les bornes prédéfinies étant connectées à la ligne de signal d'avertissement (26), chacune des bornes prédéfinies étant soit une borne de remise à l'état initial, soit une borne de mise à l'état.

8. Détecteur d'erreurs (200) selon l'une des revendications 1 à 7, dans lequel le détecteur de montée en tension (50) comprend un dispositif de détermination de durée (51) permettant de déterminer une durée d'une période (75), dans laquelle l'état non de basse tension (61) d'une tension surveillée (Us) n'a pas changé (78) à l'état de basse tension (62, 63) depuis un dernier changement (78) de l'état de basse tension (62, 63) à l'état non de basse tension (61).

9. Unité de commande sûre de basse tension (400) comprenant un détecteur d'erreurs (200) selon l'une des revendications 1 à 8 et une unité d'application (20).

10. Procédé de détection de baisse de tension (501) réalisé au niveau d'un détecteur d'erreurs (200) selon l'une des revendications 1 à 9, le procédé comprenant les étapes de :
- chargement (510a) desdites premières informations de chargement (248'a) dans ledit premier élément de stockage (244a), les premières informations de chargement (248'a) étant lesdites informations supervisées (248) codées à l'aide dudit premier mécanisme de codage ;
- chargement (510b) desdites secondes informations de chargement (248'b) dans ledit second élément de stockage (244b), les secondes informations de chargement (248b) étant lesdites informations supervisées (248) codées à l'aide dudit second mécanisme de codage ;
- réception (520) dudit signal de déclenchement (SR) à partir dudit détecteur de sortie basse tension (100) du détecteur d'erreurs (200) ;
- récupération (540a) desdites premières informations stockées (248"a) stockées dans le premier élément de stockage (244) ;
- récupération (540b) desdites secondes informations stockées (248"b) stockées dans le second élément de stockage (244b) ;
- comparaison (550) de ladite combinaison desdites premières informations récupérées (248'''a) récupérées à partir du premier élément de stockage (244a) et desdites secondes informations récupérées (248'''b) récupérées à partir du second élément de stockage (244b) à chaque motif de codage dudit ensemble de motifs valides ;
- fourniture (560) dudit signal de correspondance-non-correspondance (SM) indiquant ladite non-correspondance lorsque la combinaison des premières informations récupérées (248'''a) et des secondes informations récupérées (248'''b) ne correspond à aucun des motifs de l'ensemble de motifs valides, et fourniture dudit signal de correspondance-non-correspondance (SM) indiquant ladite correspondance lorsque la combinaison des premières informations récupérées (248'''a) et des secondes informations récupérées (248'''b) correspond à l'un quelconque des motifs de l'ensemble de motifs valides ; et
- commande (530) de ladite génération du signal de correspondance-non-correspondance (SM) indiquant la correspondance, la génération dépendant de la réception (520) du signal de déclenchement (SR) à partir dudit détecteur de sortie basse tension (100), ou commande (530) de ladite sortie du signal de correspondance-non-correspondance (SM) indiquant la correspondance, la sortie dépendant de la réception (520) du signal de déclenchement (SR) à partir dudit détecteur de sortie basse tension (100).

11. Procédé d'autoréparation en cas de baisse de tension (502) comprenant :
- les étapes du procédé de détection de baisse de tension (501) selon la revendication 10 ;
- la réalisation d'une étape :
d'identification (570) d'un contenu non valide dans les informations stockées (248"a, 248"b) stockées dans le premier (244a) et/ou le second (244b) élément de stockage ; et/ou
de retour (572) à un motif de réinitialisation, par défaut ou autre motif binaire (248'a, 248'b) qui correspond à des besoins d'application ou de système sur puce.
